# EUROPEAN PATENT APPLICATION

(11) **EP 4 622 398 A1**
(43) Date of publication of application: **24.09.2025**
(21) Application number: 24165178.5
(22) Date of filing: 21.03.2024
(51) Int. Cl.: H05K 1/02, H05K 3/34

(54) **ELECTRONIC ASSEMBLY FOR AN AUTOMOTIVE LUMINOUS DEVICE AND AN AUTOMOTIVE LUMINOUS DEVICE**

(71) Applicant: Valeo Vision, 93012 Bobigny Cedex (FR)
(72) Inventor: SANTAELLA, Juan-Jose, 23600 MARTOS (ES); HERNANDEZ-CLEDERA, Manuel, 23600 Martos (ES); MONNOT, Jerome, 23600 Martos (ES)
(74) Representative: Valeo Visibility

(57) **Abstract**

The invention provides an electronic assembly for an automotive luminous device (10). This electronic assembly comprises an electronic substrate (1), the electronic substrate (1) comprising a main circuit layer (2) and a solder mask (3), wherein the electronic substrate comprises a plurality of test points, which are zones where the solder mask (3) is absent and the main circuit layer (2) is accessible. The electronic assembly also comprises at least one solid-state light source (5) installed in the electronic substrate (1) and a light driver (4) configured to provide electric supply to the at least one solid-state light source (5) and installed in the electronic substrate (1). The electronic substrate (1) further comprises a test pin (6) in each one of a plurality of the test points.

## Description

### TECHNICAL FIELD

This invention belongs to the field of lighting devices installed in automotive vehicles, and more specifically to the electronic assemblies used in automotive lighting devices.

### STATE OF THE ART

In some lighting applications, such as automotive interior lighting, the space to locate the light sources and the associated electronics is quite small.

Light sources, and especially those which are solid-state light sources, such as Light Emitting Diodes (LEDs) produce heat during operation, and further need to keep their temperature within an established range, which is usually narrow. This range is important for their performance, in terms of output light. Further, there are other electronic elements, such as drivers, which also need proper heat dissipation to avoid malfunctioning. In summary, there is a need to keep some electronic components of automotive lighting devices under a controlled temperature.

When these solid-state light sources are installed in a small space, the possibilities to dissipate heat are reduced, since the electronic substrate where the light source and the associated electronics are installed (usually a printed circuit board, PCB) do not have the ability and the space to dissipate heat.

A solution for this problem is therefore sought.

### DESCRIPTION OF THE INVENTION

The present invention provides a solution for these problems by means of an electronic assembly for an automotive luminous device comprising:
an electronic substrate, the electronic substrate comprising a main circuit layer and a solder mask, wherein the electronic substrate comprises a plurality of test points, which are zones where the solder mask is absent and the main circuit layer is accessible;
at least one solid-state light source installed in the electronic substrate; and
a light driver configured to provide electric supply to the first light group and installed in the electronic substrate;
wherein the electronic substrate further comprises a test pin in each one of a plurality of the test points.

The electronic substrate is usually a printed circuit board (PCB). In some particular embodiments, the electronic substrate is a rigid electronic substrate. Alternatively, the substrate can be made flexible. A rigid substrate should be understood in the sense of what the skilled person would construe. A skilled person knows the difference between a rigid substrate and a flexible substrate. Although every material is "flexible" in the sense that it has a stress-strain curve, a substrate which does not deform by its own weight when held by one of its ends is deemed to be rigid, while a substrate which suffer a substantial deformation when held by one of its ends is considered to be flexible. In any case, board manufacturers offer a "flexible" model and a "rigid" model, while any skilled person knows the difference between them.

Test points are zones of the electronic substrate which are widely used in automotive elements manufacturing. They are zones where the solder mask is removed so that a copper node is accessible and the electric signal in this point can be easily measured. These copper nodes normally have a standard size which may depend on the technology used for PCB manufacturing and also on the technology used for measurement (e.g., nail bed). Further, in some cases, although they could seem as just a "point", these test points can cover a wide area of copper, which is useful for electromagnetic compatibility and for thermal behaviour as well. One example of a wider area is the ground plane in the layout of the PCB, where several test points may be located.

The invention relies on placing a plurality of test points near the electronic elements which need more heat dissipation (the driver and the light sources) and put a test pins on each one of these test points, so that these test points can be used as such (i.e., as points where the electric connection is tested) and, further, as heat dissipation elements, due to the best heat dissipation achieved by the test pins.

In some particular embodiments, the electronic substrate comprises a further circuit layer and a plurality of vias which connect some points of the main circuit layer with some points of the further circuit layer, and wherein the light source and/or the light driver is installed on the further circuit layer.

There is a possibility of using this invention with electronic substrates which comprises more than one circuit layer. In this case, the main circuit layer would comprise the test pins located in their test points and a different circuit layer (usually oriented to a face opposite to the face of the main circuit layer) receives at least some of the electronic components. Heat dissipation and electric conductivity between circuit layers are ensured by a plurality of vias which provide electric and thermal connection between the circuit layers.

In some particular embodiments, the at least one light source and/or the light driver cover an installation zone of the further circuit layer and wherein the position of at least some of the test pins are comprised in a thermal zone which corresponds to the projection of the installation zone over the plane of the electronic substrate.

Heat is more directly dissipated when the distance between the electronic component and the test pins is lower. Hence, when the position of at least some of the test pins corresponds to the projection of the zone where the electronic components (light source and/or driver) are installed, heat dissipation is optim ised.

The installation zone is understood as the projection of the light source and/or the light driver over the electronic substrate, which is essentially flat. This means the "shadow" or the "footprint" of the electronic component on the substrate. This "shadow" or "footprint" may be easily projected on the opposite side of the electronic substrate, which in this case corresponds to the face of the main circuit layer, where the test pins are installed. This is the thermal zone. Hence, the fact that at least some of the test pins fall inside the projection of this "shadow" or "footprint" on the face of the electronic substrate means that the path is lower.

In some particular embodiments, the main circuit layer and/or the further circuit layer and/or the test pins are made of copper.

Copper is the material which is commonly used to manufacture the circuit layers in the electronic substrates. Further, it has a good thermal conductivity and can be used to produce the test pins, so that the test process can be reliably performed and the heat dissipation is improved.

In some particular embodiments, the test pins may be manufactured in the same material as the main circuit layer and/or the further circuit layer, but in other embodiments, the materials can be different, as long as they provide thermal conductivity and a reliable soldering with the corresponding circuit layer.

In some particular embodiments, the plurality of test points are formed on both the main circuit layer and the further circuit layer.

In some particular embodiments, the test pins are placed on the test points on a circuit layer of the electronic substrate that is opposite to the circuit layer where the light source and/or the light driver are mounted.

In some particular embodiments, the test pins (6) are placed on the test points (7) that are arranged on the same circuit layer of the electronic substrate (1) where the light source (5) and/or the light driver (4) are mounted.

In a second inventive aspect, the invention provides an automotive luminous device comprising
an electronic assembly according to the first inventive aspect; and
an optical element arranged to receive light emitted from the at least one light source and project it outside the luminous device.

This luminous device is able to provide a luminous function without requiring a big amount of space in the automotive vehicle structure.

In some particular embodiments, the optical element is a light guide or a reflector.

An optical element is an element that has some optical properties to receive a light beam and emit it in a certain direction and/or shape, as a person skilled in automotive lighting would construe without any additional burden. Reflectors, collimators, light guides, projection lenses, etc., or the combination thereof are some examples of these optical elements which are useful for transforming the light beams emitted by the light source into an acceptable light pattern for the functionality chosen for the lighting device.

In some particular embodiments, the solid-state light source is a light emitting diode.

The term "solid state" refers to light emitted by solid-state electroluminescence, which uses semiconductors to convert electricity into light. Compared to incandescent lighting, solid state lighting creates visible light with reduced heat generation and less energy dissipation. The typically small mass of a solid-state electronic lighting device provides for greater resistance to shock and vibration compared to brittle glass tubes/bulbs and long, thin filament wires. They also eliminate filament evaporation, potentially increasing the lifespan of the illumination device. Some examples of these types of lighting comprise semiconductor light-emitting diodes (LEDs), organic light-emitting diodes (OLED), or polymer light-emitting diodes (PLED) as sources of illumination rather than electrical filaments, plasma or gas. These light sources are specifically advantageous, since they provide the required luminous properties for the automotive regulations with a high efficiency and reliability.

In some particular embodiments, the at least one light source is configured to cooperate to provide an interior lighting function.

Lighting or signalling functions which require a reduced space will receive a higher benefit from this invention, since heat dissipation requirements are met without the need of substantially increasing the size of the electronic circuit.

Unless otherwise defined, all terms (including technical and scientific terms) used herein are to be interpreted as is customary in the art. It will be further understood that terms in common usage should also be interpreted as is customary in the relevant art and not in an idealised or overly formal sense unless expressly so defined herein.

In this text, the term "comprises" and its derivations (such as "comprising", etc.) should not be understood in an excluding sense, that is, these terms should not be interpreted as excluding the possibility that what is described and defined may include further elements, steps, etc.

### BRIEF DESCRIPTION OF THE DRAWINGS

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:
Figure 1 shows the interior of an automotive vehicle comprising an interior light according to the invention.
Figure 2 shows a scheme of a first particular embodiment of an electronic assembly for the interior light shown in Figure 1.
Figure 3 shows a perspective view of the arrangement of Figure 2, to show the position of the test points and the position of the test pins which are installed in some of these test points.
Figure 4 shows a scheme of a second particular embodiment of an electronic assembly for the interior light shown in Figure 1.

In this document, the following reference numbers have been used:
- 1: PCB
- 2: Top circuit layer
- 3: Soldermask
- 4: Light driver
- 5: LED
- 6: Test pins
- 7: Test point
- 8: Bottom circuit layer
- 9: Light guide
- 10: Interior light
- 11: User
- 12: Vias
- 13: Thermal zone
- 100: Automotive vehicle

### DETAILED DESCRIPTION OF THE INVENTION

The example embodiments are described in sufficient detail to enable those of ordinary skill in the art to embody and implement the systems and processes herein described. It is important to understand that embodiments can be provided in many alternate forms and should not be construed as limited to the examples set forth herein.

Accordingly, while embodiment can be modified in various ways and take on various alternative forms, specific embodiments thereof are shown in the drawings and described in detail below as examples. There is no intent to limit the scope of protection to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

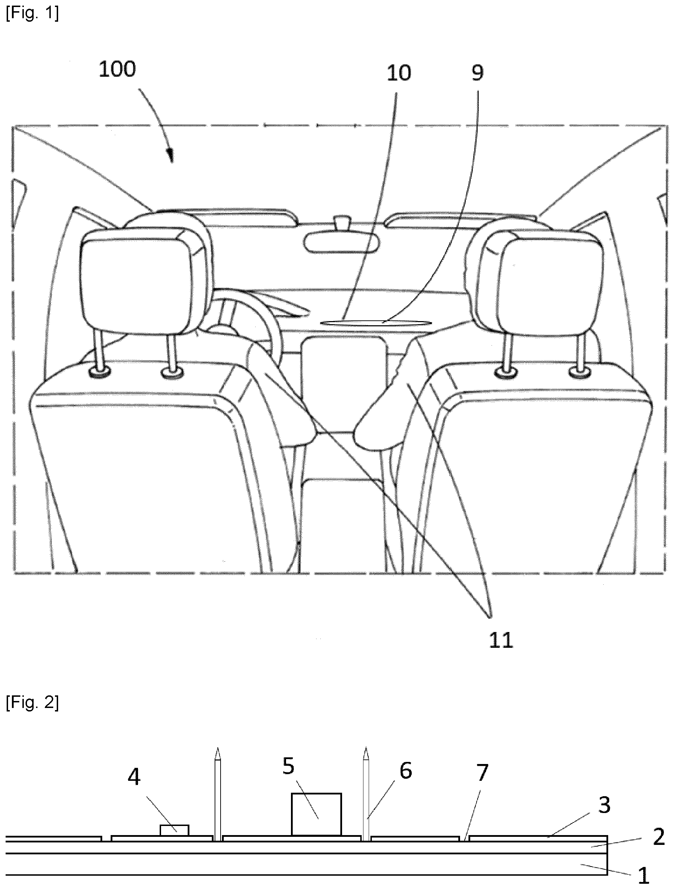

Figure 1 shows the interior of an automotive vehicle 100. This vehicle 100 comprises an interior light 10, which is a device which is configured to emit light to help the users 11 see inside the cockpit of the automotive vehicle when the ambient lighting is poor. Usually, the interior lights are installed in the cockpit with limited space constraints. Due to limited space availability, the interior lighting systems do not have elaborate lighting arrangements such as for example, reflectors, and heatsinks. In some embodiments,the interior light 10 comprises a lightguide 9, which distributes the light which is produced by an interior LED (not seen in this image). In some embodiments, the LEDs may be configured to directly emit light in the cockpit of the automotive vehicle 100. However, in any case the LEDs that emit light also generate heat, and the space constraints make it challenging to use the heatsinks for cooling the LEDs used in interior ambient lights.

Figure 2 shows a scheme of a first particular embodiment of an electronic assembly for such an interior light.

This electronic assembly comprises a printed circuit board (PCB) 1. In this case, this PCB 1 comprises a circuit layer, which is referred to as a top circuit layer 2. The PCB 1 also comprises a solder mask 3 and a plurality of test points 7, which are zones where the solder mask 3 is absent, and the top circuit layer 2 is accessible from the outside, to perform tests. The tests performed may be for example, continuity test, functional testing, in-circuit testing and the like. These test points 7 usually coincide with electric nodes, so that a tester may be connected to the test points 7 and check if the electric connections are done correctly. This figure is an example scheme in lateral view to present the elements of the invention, so the number and location of these test points 7 are represented for a better understanding of the invention.

The PCB 1 also comprises a light source such as, for example, an LED 5, and a driver 4, which are installed on the top circuit layer 2. The test pins 6 are placed on the test points 7 on a side of the PCB 1 where the light source 5 and/or the light driver 4 are mounted. The driver 4 is in charge of controlling the electric supply received by the LED 5. Both, the light source 5 and the driver 4 may generate heat during the course of operation. In other embodiments, instead of a single LED 5, which is now used for illustrative purposes, a light group with more than one LED, or any other type of light sources, may be used. When more light sources 5 are used, the driver 4 may also be required to supply sufficient current to drive all the LEDs 5 and hence the heat generated also increases substantially. The heat generated by the heat generating components also affects the performance of the PCB 1 on which they are mounted.

The invention relies on placing a plurality of test points 7 near the electronic elements which need more heat dissipation (for example, the driver 4 and the light sources 5) and inserting a test pin 6 on each one of these test points 7, so that these test points 7 can be used as such (i.e., as points where the electric connection is tested) and, in addition, as heat dissipation elements, due to the conductivity of the test pins 6. The metallic test pins 6 transfer heat generated by the light source, i.e, LED 5 disposed on the PCB 1 by thermal conduction. The test pins 6 can subsequently be cooled either by ambient air or by forced convection or by any other known cooling arrangement. Thus, the heat generated by the light source 5 is dissipated by the test pins 6. The number and position of the test points 7 depends on the possibilities of the electric design and on the heat dissipation necessities. Further, in some cases there may be test points without a test pin located therein. Figure 2 intends to provide a general approach to the invention by a scheme of the test points and test pins in relation to the position of the relevant electronic components (the LED and the driver).

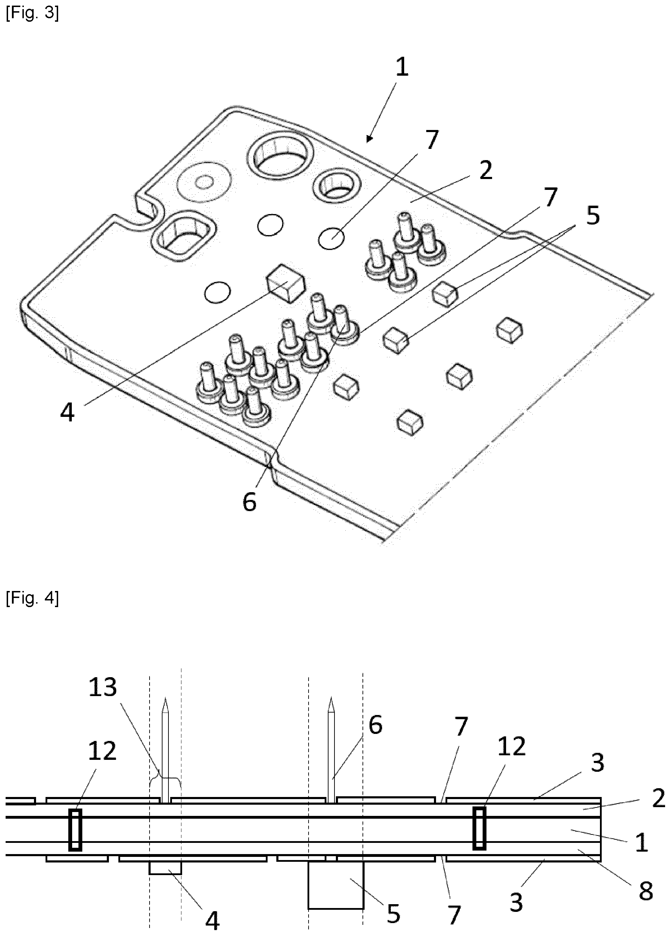

Figure 3 shows a perspective view of this arrangement, where the position of the test points 7 and the position of the test pins 6 which are installed in some of these test points 7 is shown.

The PCB 1 has many test points 7, but only some of them (those which are closer to the LED 5 and to the driver 4) have test pins 6. These test pins 6 do not modify the ability of the test points to act as such, since the test pins 6 are manufactured in the same material (usually copper) than the top circuit layer 2 (and hence, in the same material as the test points 7, which are unveiled portions of the top circuit layer 2). Further, these test pins 6, due to its protruding shape, acts as a heatsink, so they contribute to heat dissipation due to their location close to the light source 5 and to the driver 4.

Figure 4 shows a scheme of a second particular embodiment of an electronic assembly for such an interior light.

This electronic assembly comprises a printed circuit board (PCB) 1. In this case, this PCB 1 comprises two circuit layers, the first one is called top circuit layer 2 and the second one is called bottom circuit layer 8. The PCB 1 also comprises a solder mask 3 over the top circuit layer 2 and a solder mask 3 over the bottom circuit layer 8. Both the top circuit layer 2 and the bottom circuit layer 8 comprise test points 7. The top circuit layer 2 and the bottom circuit layer 8 are connected by vias 12 which ensure the electric connection in strategic points between the two circuit layers 2, 8.

Needless to say, the invention can be extended to a larger number of circuit layers, since the only requirement is that the test pins are installed in an exterior layer (either the top one or the bottom one).

In this case, the LED 5 and the driver 4, are installed on the bottom circuit layer 8. As in the case of Figures 2 and 3, the driver 4 is in charge of controlling the electric supply received by the LED 5. In other embodiments, instead of a single LED 5, which is now used for illustrative purposes, a light group with more than one LED, or any other type of light sources, may be used.

The main difference is that in this case, the test pins 6 are installed on test points which are located in an opposite circuit layer from the one where the driver 4 and the LED 5 are mounted.

The light source and the light driver define an "installation zone", which can be defined as the projection of the light source and the light driver over the PCB 1. This means the "shadow" or the "footprint" of the electronic component on the substrate. This "shadow" or "footprint" may be easily projected (i.e., translated) on the opposite side of the electronic substrate, which in this case corresponds to the face of the main circuit layer, where the test pins 6 are installed. This projection over the opposite side of the PCB is the thermal zone 13. The test pins 6 are installed on the test points 7 in the thermal zone 13. Hence, the fact that at least some of the test pins fall inside the projection of this "shadow" or "footprint" on the face of the electronic substrate means that the path is shorter and heat can be more easily dissipated. The term "projection" should be understood as in technical drawing: the translation of a surface from one plane to another. In this case, the translation of the footprint of the electronic component from the plane of one side 2 of the PCB 1 to the plane of the other side 8.

This concept of installing test pins on the projection of this "footprint" over the other layer can also be applied in the event that the LED is installed in one layer (for example, the top one) and the driver is installed in the opposite layer (i.e., the bottom one). In this case, some test pins could be installed in the bottom one (following the projection of the footprint of the LED over the bottom layer) and some test pins could be installed in the top layer (following the projection of the driver over the top layer).

## Claims

1. An electronic assembly for an automotive luminous device (10) comprising:
an electronic substrate (1), the electronic substrate (1) comprising a main circuit layer (2) and a solder mask (3), wherein the electronic substrate (1) comprises a plurality of test points (7), wherein the test points (7) are zones where the solder mask (3) is absent and the main circuit layer (2) is accessible;
at least one solid-state light source (5) installed in the electronic substrate (1);
a light driver (4) configured to provide electric supply to the at least one solid-state light source (5) and installed in the electronic substrate (1);
wherein
the electronic substrate (1) further comprises a test pin (6) in each of the plurality of test points (7).

2. Electronic assembly according to claim 1, wherein the electronic substrate (1) comprises a further circuit layer (8) and a plurality of vias (12) which connect some points of the main circuit layer (2) with some points of the further circuit layer (8), and wherein the light source (5) and/or the light driver (4) is installed on the further circuit layer (8).

3. Electronic assembly according to claim 1, wherein the at least one light source (5) and/or the light driver (4) cover an installation zone of the further circuit layer (8) and wherein the position of at least some of the test pins (6) are comprised in a thermal zone (13) which corresponds to the projection of the installation zone over the plane of the electronic substrate (1).

4. Electronic assembly according to any of the preceding claims, wherein the main circuit layer (2) and/or the further circuit layer (8) and/or the test pins (6) are made of copper.

5. Electronic assembly according to any of the preceding claims, wherein the plurality of test points (7) are formed on both the main circuit layer (2) and the further circuit layer (8).

6. Electronic assembly according to any of the preceding claims, wherein the test pins (6) are placed on the test points (7) on a circuit layer of the electronic substrate (1) that is opposite to the circuit layer where the light source (5) and/or the light driver (4) are mounted.

7. Electronic assembly according to any of the preceding claims, wherein the test pins (6) are placed on the test points (7) that are arranged on the same circuit layer of the electronic substrate (1) where the light source (5) and/or the light driver (4) are mounted.

8. Automotive luminous device (10) comprising
an electronic assembly according to any of the preceding claims; and
an optical element (9) arranged to receive light emitted from at least one light source and project it outside the luminous device (10).

9. Automotive luminous device (10) according to claim 8, wherein the optical element is a light guide (9) or a reflector.

10. Automotive luminous device (10) according to any of claims 8 or 9, wherein the solid-state light sources are light emitting diodes (5).

11. Automotive luminous device (10) according to any of claims 8 to 10, wherein the at least one light source is configured to provide an interior lighting function.
